# EUROPEAN PATENT APPLICATION

(11) **EP 3 026 752 A1**
(43) Date of publication of application: **01.06.2016**
(21) Application number: 15196345.1
(22) Date of filing: 25.11.2015
(51) Int. Cl.: H01M 10/44, H01M 10/48, H02J 7/00, G01R 31/36, H01M 10/42

(54) **BATTERY PACK AND METHOD FOR CONTROLLING THE SAME**

(30) Priority: 27.11.2014 KR 20140167451
(71) Applicant: Samsung SDI Co., Ltd., Gyeonggi-do 17084 (KR)
(72) Inventor: KIM, Ho Sung, Gyeonggi-do 17084 (KR)
(74) Representative: Taor, Simon Edward William

(57) **Abstract**

Provided is a battery pack, including a plurality of battery units (1,3,5,7) capable of being recharged and a battery management system (30) configured to control charging and discharging of the plurality of battery units, wherein the battery management system calculates an idle state time of the plurality of battery units by monitoring the plurality of battery units and, if the idle state time exceeds a preset time, the battery management system moves electrical energy from any one of the plurality of battery units to a different battery unit, so as not to include a state of charge (SOC) value of each of the plurality of battery units in a preset scope, wherein the capacity recovery rate of the battery unit is lower, thus potentially increasing the lifetime of the battery pack.

## Description

Embodiments relate to a battery pack and a method of controlling the same.

Generally, a battery cell is used as an energy source for a mobile device, an electric vehicle, a hybrid vehicle, electricity and the like. Depending on the type of the external device to which it is applied, the form may change.

Low capacity batteries may be used in small electronic devices capable of being carried around such as mobile phones, notebooks, computers and camcorders, and large capacity batteries may be used as power source for driving motors such as hybrid or electric vehicles. If long term driving or high electric power driving is required, large capacity battery module is composed by electronically coupling a plurality of battery cells in order to increase output and capacity. A battery module may increase output voltage or output current depending on the number of battery cells internally mounted. A battery pack may be composed by electronically coupling a plurality of such battery modules.

Each battery cell may include an electrode assembly including an anode and a cathode on both sides of a separator, a case internally mounting the electrode assembly and an electrode terminal electronically coupled to the electrode assembly and extending external to the case.

With repeated charging and discharging, life and performance of a battery cell may decrease or deteriorate, and therefore, it may not serve as a stable and sufficient power source. Therefore, much interest has been aroused and research is being conducted to decrease performance deterioration and life of a battery cell in order to use a battery more efficiently.

Embodiments may be realized by providing a battery pack, including, a plurality of battery units capable of being recharged and a battery management system configured to control charging and discharging of the plurality of battery units, wherein the battery management system calculates idle state time of the plurality of battery units by monitoring the plurality of battery units and, if the idle state time exceeds preset time, so as not to include a state of charge (SOC) value of each of the plurality of battery units in a preset scope, the battery management system moves electrical energy from any one of the plurality of battery units to a different battery unit, thereby controlling charging and discharging of the plurality of battery units.

The battery pack may further include a switch unit at the plurality of battery units and a direct current-to-direct current (DC-DC) converter coupled to at least any one of the plurality of battery units through the switch unit.

The battery management system may control the DC-DC converter and the switch unit to move electrical energy between the plurality of battery units.

The battery management system may controls the switch unit of a battery unit that is to supply and receive electrical energy among the plurality of battery units such that a switch unit coupled to a battery unit that is discharged among switch units coupled to one end of the DC-DC converter and a switch unit coupled to a battery unit that is charged among the switch units coupled to other end of the DC-DC converter are turned on.

The battery management system may select a second battery unit that is to supply and receive electrical energy to and from the first battery unit if there is a first battery unit having a SOC value that is included in the preset scope among the plurality of battery units.

The battery management system may calculate a movement amount of electrical energy that the first battery unit is to transfer to the second battery unit or that the first battery is to receive from the second battery unit.

The battery management system may select any one of the plurality of battery units including a SOC value that is not included in the preset scope as the second battery unit.

The battery management system, if there is a first battery unit having a SOC value that is included in the preset scope among the plurality of battery units, may select a battery unit having a smallest SOC value among the plurality of battery units except for the first battery unit and controls such that electrical energy stored in the first battery unit moves to the second battery unit.

The battery management system may re-calculate the SOC value of each of the plurality of battery units if the SOC value of the first battery unit continues to be included in the preset scope even though the second battery unit is in a fully charged state because electrical energy is transferred from the first battery unit to the second battery unit and re-selects the battery unit having the smallest SOC value among the battery units having the SOC values of the plurality of battery units that are not included in the preset scope as a second battery unit.

The battery management system, if there is a first battery unit having a SOC value that is included in the preset scope among the plurality of battery units, may select a battery unit having a largest SOC value among the other battery units except for the first battery unit as a second battery unit and control such that the first battery unit receives electrical energy from the second battery unit.

The battery management system, if electrical energy stored in the second battery unit is the same or smaller than the movement amount of electrical energy, may control such that electrical energy stored in the first battery unit moves to the second battery unit.

The battery management system, if there are a plurality of first battery units having SOC values included in the preset scope among the plurality of battery units, may control such that electrical energy moves between the first battery units.

In an embodiment, there is provided a method of controlling a battery pack including a plurality of battery units capable of being recharged and a battery management system configured to control charging and discharging of the plurality of battery units, including, determining whether the plurality of battery units are in idle state by monitoring the plurality of battery units, determining whether there is a battery unit having a SOC value included in a preset scope among the plurality of battery units and controlling charging and discharging of the plurality of battery units by moving electrical energy between the plurality of battery units such that the SOC value of each of the plurality of battery units is out of the preset scope if idle state time of the plurality of battery units exceeds preset time and there is a battery unit having a SOC value that is included in the preset scope among the plurality of battery units.

According to an aspect of the invention, there is provided a battery management system as set out in claim 1. Preferred features are set out in claims 2 to 13.

According to an aspect of the invention, there is provided a method as set out in claim 14.

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey the scope of the example embodiments to those skilled in the art.

In the drawing figures, dimensions may be exaggerated for clarity of illustration. It will be understood that when an element is referred to as being "between" two elements, it can be the only element between the two elements, or one or more intervening elements may also be present. Like reference numerals refer to like elements throughout.
FIG. 1 schematically illustrates a battery pack.
FIG. 2 describes charging and discharging operations of a battery unit shown in FIG. 1.
FIG. 3 compares battery units having different SOC values, on a unit-by-unit basis, and describes a state in which life of a battery unit changes as idle state of a battery unit is prolonged.
FIG. 4 is a flow chart illustrating an overall flow of a method for controlling a battery pack according to an embodiment.

In the following detailed description, only certain exemplary embodiments of the present invention have been shown and described, simply by way of illustration. As those skilled in the art would realize, the described embodiments may be modified in various different ways, all without departing from the spirit or scope of the present invention. Accordingly, the drawings and description are to be regarded as illustrative in nature and not restrictive. In addition, it will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of the invention. As used herein, the singular forms, "a", "an" and "the" are intended to include the plural forms as well, unless the context clearly indicates otherwise. It will be further understood that the terms "includes" and/or "including", when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

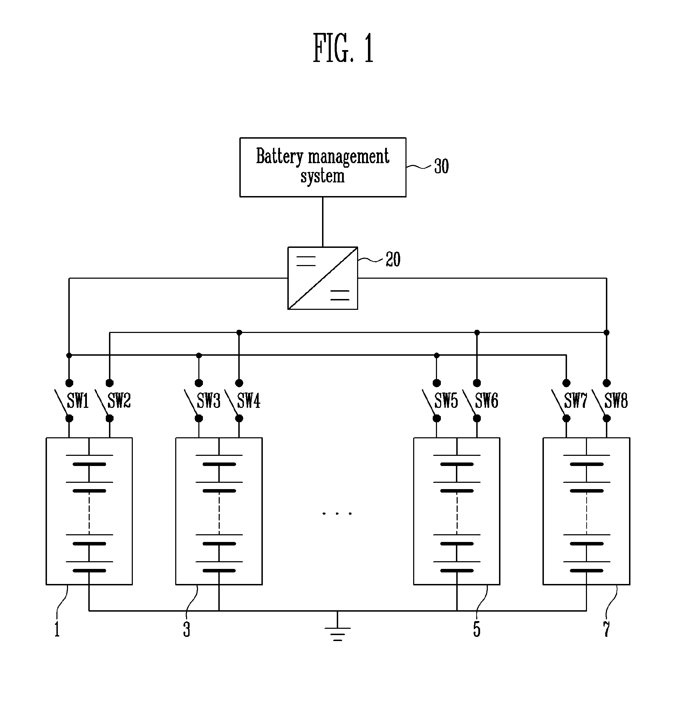

FIG. 1 schematically illustrates a battery pack.

As illustrated in FIG. 1, a battery pack may include a plurality of battery units 1, 3, 5 and 7, a direct current-to-direct current (DC-DC) converter 20, switch units SW1 to SW8 configured to couple the battery units 1, 3, 5 and 7 and the DC-DC converter 20 and a battery management system 30.

The battery units 1, 3, 5 and 7 according to an embodiment may include at least one battery cell. For battery cells forming the battery units 1, 3, 5 and 7, a secondary battery capable of being charged and discharged depending on consumption or supply of electrical energy may be used. For example, a secondary battery may include a nickelcadmium battery, a lead storage battery, a nickel metal hydride battery, a lithium battery, a lithium polymer battery and the like, but a type of secondary battery is not limited hereto in embodiments of the invention.

The switch units SW1 to SW8 according to an embodiment may be included at anode terminals of the battery units 1, 3, 5 and 7, and cathode terminals of the battery units 1, 3, 5 and 7 may be coupled to a ground contact part. A portion of the switch units SW1, SW3, SW5 and SW7 included at the battery units 1, 3, 5 and 7, respectively, may be coupled to one end of the DC-DC converter 20. The remaining switch units SW2, SW4, SW6 and SW8 included at the battery units 1, 3, 5 and 7, respectively, may be coupled to the other end of the DC-DC converter 20.

Meanwhile, FIG. 1 illustrates four battery units provided in a battery pack, but embodiments of the present invention are not limited hereto. However, there may be 2 battery units such that the battery units may supply and receive electrical energy between each other.

The DC-DC converter 20 according to an embodiment may be a bi-directional converter and may be coupled to each of the battery units 1, 3, 5 and 7 as the switch units SW1 to SW8 are turned on or off. The DC-DC converter 020 may, when the battery units 1, 3, 5 and 7 are discharged, supply a direct current power of the battery units 1, 3, 5 and 7 to a direct current (DC) link (not shown) by converting it into a direct current power having a different level or by converting the direct current power from the DC link into direct current power having a proper level for the battery units 1, 3, 5 and 7 such that the battery units 1, 3, 5 and 7 are charged. Also, the DC-DC converter 20 may provide direct current power of any one of the battery units among the plurality of battery units, 1, 3, 5 and 7 shown in FIG. 1 to other battery units excluding the battery unit.

The battery management system 30 according to an embodiment may monitor current flow state, voltage, temperature and the like of the battery units 1, 3, 5 and 7. The battery management system 30 may calculate a value of a state of charge (SOC) of the battery units using the current, voltage, temperature and the like of the battery units 1, 3, 5 and 7. The battery management system 30 may control charging and discharging of the battery units 1, 3, 5 and 7 referring to the monitoring results or the calculated SOC value. Particularly, charging and discharging may be controlled by moving electrical energy between the battery units 1, 3, 5 and 7.

Also, the battery management system 30 may determine whether the battery units 1, 3, 5 and 7 are in an action state or idle state and calculate time during which the idle state persists by monitoring the battery units 1, 3, 5 and 7. The battery management system 30 may determine a state in which charging and discharging operations are not performed with respect to the plurality of battery units 1, 3, 5 and 7 as the idle state and a state in which either charging or discharging is performed as the action state. The battery management system 30 may control charging and discharging of the plurality of battery units 1, 3, 5 and 7 by referring to SOC values of each of the plurality of battery units 1, 3, 5 and 7 when the plurality of battery units 1, 3, 5 and 7 are in the idle state, idle state time exceeding preset time T.

The battery management system 30 may determine whether the plurality of battery units 1, 3, 5 and 7 are in the idle state such that the idle state time exceeds the preset time T. If the plurality of battery units 1, 3, 5 and 7 are in the idle state with the idle state time exceeding the preset time T, the battery management system 30 may move electrical energy from any one of the plurality of battery units 1, 3, 5 and 7 to other battery units and control charging and discharging of the plurality of battery units 1, 3, 5 and 7.

A method of controlling movement of electrical energy between the battery units will be described below.

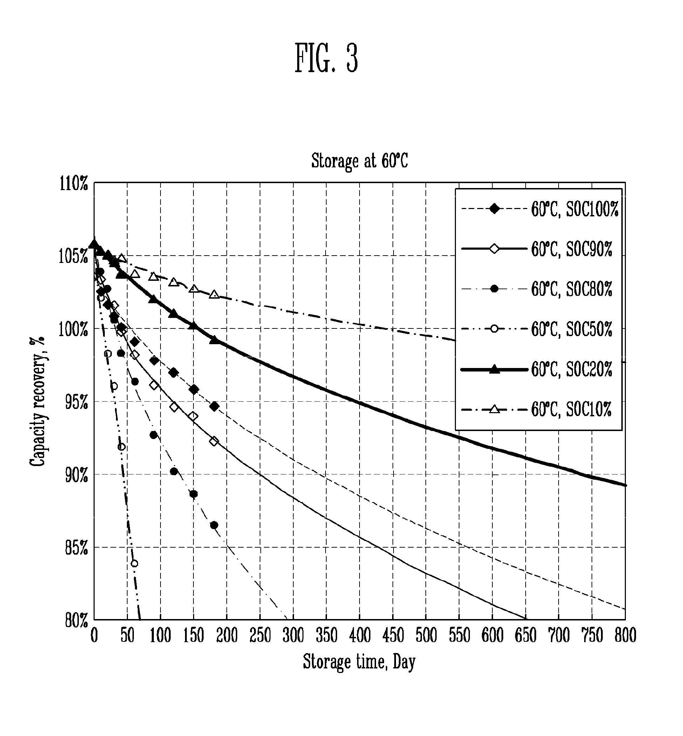

For purposes of convenience, the preset scope (or preset range) is described to be from 40% to 60%, but embodiments of the present invention is not limited hereto. The preset scope may be set to be 50±Δ(%). Depending on desired life of the battery unit, the preset scope may be adjusted by changing the Δ value. Setting the preset scope to be 50±Δ(%) will be described below with reference to FIG. 3.

Although not illustrated in FIG. 1, for the battery pack, the battery management system 30 may further include terminals for measuring the current flow state, voltage, temperature and the like or monitoring charging/discharging state or current flow. Although not illustrated in FIG. 1, the battery pack may further include a DC link for temporarily storing direct current voltage output from the DC-DC converter or inverter, an inverter for outputting by converting the direct current power provided from the DC link into commercial alternating current power source, and the like. The battery pack may also include an input/output terminal unit for supplying power of the battery pack as an external load or receiving power from an external power source.

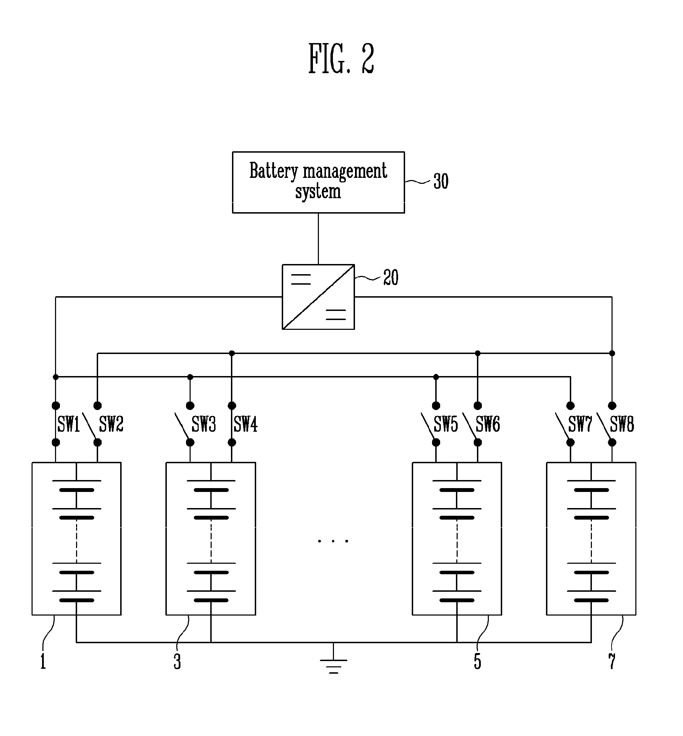

FIG. 2 describes charging and discharging operations of a battery unit shown in FIG. 1.

A battery management system 30 may control a DC-DC converter and a switch unit such that two battery units of a plurality of battery units 1, 3, 5 and 7 are charged and discharged, or discharged and charged, respectively, as electrical energy moves between the two battery units.

The battery management system 30, in controlling the switch unit so that the battery units may supply and receive electrical energy between them, may control the switch unit coupled to the battery units that are to supply and receive electrical energy to be turned on, but may control so that only one of two switch units coupled to the battery units, respectively, is turned on.

As for a battery unit that is discharged by releasing stored electrical energy, the battery management system 30 may control such that switch units SW1, SW3, SW5 and SW7 coupled to one end of the DC-DC converter 20 among the switch units at the battery unit are turned on. As for a battery unit that is charged by receiving electrical energy, the battery management system 30 may control such that any one of switch units SW2, SW4, SW6 and SW8 coupled to the other end of the DC-DC converter 20 is turned on.

For example, the battery management system 30 may output a control signal such that the switch units SW1 and SW4 are turned on when electrical energy moves from a battery unit having reference numeral 1 to a battery unit having reference numeral 3 in the drawing. When the switch units SW1 and SW4 are turned on due to the control signal of the battery management system 30, the battery unit having reference numeral 1 and the battery unit having reference numeral 3 may be coupled through the DC-DC converter 20 and electrical energy stored in the battery unit having reference numeral 1 may move to the battery unit having reference numeral 3.

Although electrical energy is described as moving between two battery units with reference to FIG. 2, embodiments of the present invention are not limited hereto. The battery management system 30 may control such that electrical energy may move between 3 or more battery units. For example, if the battery management system 30 controls such that the battery unit having reference numeral 3 is charged by receiving electrical energy stored in the battery unit having reference numeral 5, the battery management system 30 may simultaneously control charging and discharging of battery units having reference numerals 1, 3 and 5 by turning on SW1, SW4 and SW5.

In an embodiment, if idle state of the plurality of battery units 1, 3, 5 and 7 persists such that it exceeds preset time T and if there is a battery unit among the plurality of battery units 1, 3, 5 and 7 having a SOC value that is included in a preset scope, the battery management system 30 may determine the battery unit having the SOC value that is included in the preset scope as a first battery unit, and may select a second battery unit that is charged by receiving electrical energy stored in the first battery unit such that the SOC value of the first battery unit is out of the preset scope or is discharged by transferring electrical energy to the first battery unit.

The battery management system 30 may transfer electrical energy from the first battery unit to the second battery unit such that that the SOC value of the first battery unit is out of the preset scope or calculate a movement amount of the electrical energy that the first battery unit is to receive from the second battery unit. Here, information such as the SOC value of the first battery unit, the SOC value of the second battery unit and whether electrical energy stored in the first battery unit or the second battery unit when electrical energy is moved will be 0 may be referred to.

The battery management system 30 may receive electrical energy from the second battery unit such that the SOC value of the first battery unit is out of the preset scope or transfer electrical energy to the second battery unit but may calculate the movement amount of electrical energy such that the changed SOC value of the second battery unit is not included in the preset scope after electrical energy moves between the first battery unit and the second battery unit.

The battery management system 30 may control such that electrical energy moves from the first battery unit to the second battery unit in order to prevent the SOC value of the second battery unit from becoming 0% if electrical energy stored in the second battery unit is smaller than the movement amount of electrical energy.

If there are at least 2 first battery units having SOC values included in the preset scope among the plurality of battery units, the battery management system 30 may control such that the plurality of first battery units supply and receive electrical energy such that the SOC value of the first battery unit is out of the preset scope. For example, if the idle state of the battery unit persists to exceed the preset time T and if there are 2 battery units 1 and 3 having 50% as SOC values, respectively, the battery management system 30 may control such that electrical energy moves from the first battery unit having reference numeral 1 to the first battery unit having reference numeral 3 by turning on the switch unit SW1 coupled to the first battery unit having reference numeral 1 and the switch unit SW4 coupled to the first battery unit having reference numeral 3. The battery management system 30 may control such that the SOC values of 2 first battery units are out of the preset scope by having the SOC value of the battery unit having reference numeral 1 be 25% and the SOC value of the battery unit having reference numeral 3 be 75% after moving electrical energy.

The battery management system 30 may select a battery unit whose SOC value is not included in the preset scope as the second battery unit in receiving electrical energy from the first battery unit or selecting a second battery unit that is to transfer electrical energy y to the first battery unit. While the battery management system 30 may improve life of the first battery unit by controlling such that the SOC value of the first battery unit is out of the preset scope, it may also improve life of the second battery unit after movement of electrical energy compared to life of the second battery unit before movement of electrical energy.

As described later with reference to FIG. 3, life may be improved in the idle state if the SOC value of the battery unit is either high capacity or low capacity. The second battery unit may make the SOC value to be closer to high capacity or may transfer electrical energy to the first battery unit such that the SOC value is made closer to low capacity, thereby improving life when it is in the idle state. For example, if a first battery unit has a SOC value of 45%, and if there is a battery unit having a SOC value of 85%, after selecting the battery unit as a second battery unit, the SOC value of the first battery unit may be controlled to be 30% and the SOC value of the second battery unit may be controlled to be 100%, thereby improving life of both the first battery unit and the second battery unit.

In another embodiment, if idle state of a plurality of battery units 1, 3, 5 and 7 persists to exceed preset time T and if there is a first battery unit having a SOC value that is included in a preset scope, a battery management system 30 may select a second battery unit that is to receive electrical energy stored in the first battery unit so that the SOC value of the first battery unit may be out of the preset scope. Here, a battery unit having a smallest SOC value among battery units except for the first battery unit may be selected as the second battery unit.

However, even if the battery unit having the smallest SOC value among the battery units may be selected as the second battery unit, if there is a battery unit having a SOC value that is close to 100% except for the first battery unit, then an amount of electrical energy to be delivered may be greater than remaining storage capacity of the second battery unit such that the SOC value of the first battery unit is out of the preset scope. Here, electrical energy of the first battery unit may be moved such that the SOC value of the second battery unit becomes 100%, and a second battery unit that is to receive electrical energy of the first battery unit may be re-selected by calculating again a SOC value of a battery unit. That is, a battery unit having a smallest SOC value among battery units except for the first battery unit a battery unit whose SOC value is 100% may be re-selected as a second battery unit.

In another embodiment, if idle state of a plurality of battery units persist to exceed preset time T and if there is a first battery unit having a SOC value that is included in a preset scope, a battery management system 30 may select a second battery unit that is to transfer electrical energy to the first battery unit such that the SOC value of the first battery unit is out of the preset scope. Here, a battery unit having a greatest SOC value among battery units except for the first battery unit may be selected as the second battery unit. Here, the SOC value of the second battery unit may be controlled such that it may not be 0 after charging and discharging are controlled.

FIG. 3 compares battery units having different SOC values, on a unit-by-unit basis, and describes a state in which life of a battery unit changes as idle state of a battery unit is prolonged.

A horizontal axis of a graph illustrated in FIG. 3 is related to time t during which idle state persists, a vertical axis is related to capacity recovery rate of a battery unit. Referring to FIG. 3, as the idle state of the battery unit is prolonged, the recovery rate of the battery unit decreases. However, if the idle state of the battery unit having a SOC value of 50% persists, the recovery rate may rapidly decrease in the event the idle state of a battery unit having a different SOC value persists.

On the other hand, if idle state of a high capacity battery unit having a SOC value of 80% or greater persists, the recovery rate may decrease at a relatively slower rate compared to when the idle state of the battery unit having the SOC value of 50%. Particularly, for battery units having SOC values close to 100%, the rate at which the capacity recovery rate decreases may decrease more and more. Referring to FIG. 3, if idle state of low capacity battery unit having a SOC value of 20% or less persists, the capacity recovery rate may decrease at a relatively lower rate than in the case of a battery unit having a SOC value of 50%. Particularly, for battery units having SOC values close to 10%, the rate at which the recovery rate decreases may decrease more and more.

If the idle state of a battery unit persists, life of the battery unit may change depending on a SOC value of the battery unit. The longer the idle state, the greater the difference in life between battery units.

Consequently, if the idle state of a battery unit persists, in order to prevent life of the battery unit from being rapidly deteriorated, it may be necessary to adjust the SOC value of the battery unit. The battery management system may set a SOC section in which the recovery rate decreases the fastest and control such that the SOC value of the battery unit may be out of the section. Particularly, the battery management system may control the SOC value of the battery unit such that it may be out of the scope, 50±Δ(%), which is where life of the battery unit decreases the fastest, thereby preventing life of the battery unit from rapidly decreasing. However, as described above, not only the life of the battery unit, but also if performance of a battery pack when an operation of the battery unit commences is also considered, the SOC value may be controlled such that it does not become o.

The battery management system 30 may monitor a battery unit, and if a SOC value of the battery unit is included in a preset scope when idle state of the battery unit exceeds preset time, in other words, if it is included in a scope where life of the battery unit rapidly decreases, may adjust the SOC value by charging or discharging the battery unit, thereby improving life of the battery unit. Furthermore, since electrical energy moves between battery units, an entire amount of energy of the battery pack may be maintained in a consistent manner.

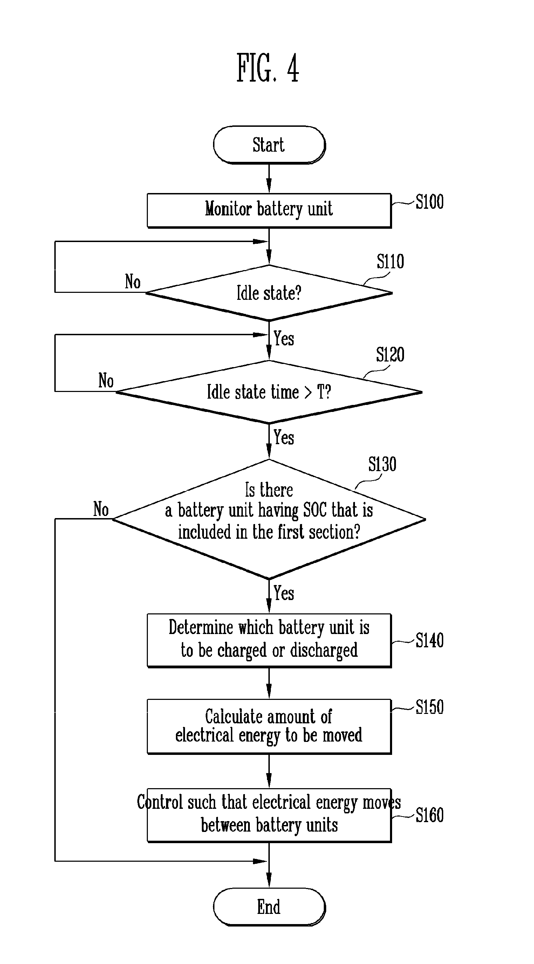

FIG. 4 is a flow chart illustrating an overall flow of a method for controlling a battery pack according to an embodiment.

Referring to FIG. 4, a battery management system according to an embodiment may monitor each of the battery units (S100). The battery management system may calculate a SOC value of each of the battery units from a data value obtained from monitoring the battery units (for example, the flow of the charging and discharging current of the battery unit, voltage, temperature, and the like) and determine whether the battery unit is in an action state or idle state.

If the battery unit is in the idle state, the battery management system, may measure t, time during which the idle state persists, and compare the t with preset time T (S110 and S120).

If the battery management system determines that the t is greater than the T, it may determine which battery unit has a SOC value, among a plurality of battery units, that is included in a first section (50±Δ(%)) (S130).

If there is a first battery unit having a SOC value that is included in the first section, the battery management system may receive electrical energy stored in the first battery unit or select a second battery unit that is to transfer electrical energy to the first battery unit such that the SOC value of the first battery unit is out of the first section (S140).

The battery management system may calculate an amount of electrical energy that is to be transferred to the second battery unit or that is to be received from the second battery unit such that the SOC value of the first battery unit is out of the first section (S150).

As discussed, embodiments of the invention can provide a battery pack, comprising: a plurality of battery units capable of being recharged; and a battery management system configured to control charging and discharging of the plurality of battery units. The battery management system is arranged to calculate an idle state time of the plurality of battery units by monitoring the plurality of battery units.

If the idle state time exceeds a preset time, the battery management system is arranged to transfer electrical energy from a battery unit having a SOC value in a preset range to another of the plurality of battery units, thereby controlling charging and discharging of the plurality of battery units. In such embodiments, the SOC value of the plurality of battery units can be controlled such that the SOC value of idle battery units is not within the preset range or the time in which idle batteries have their SOC values in the present range is minimised.

Charge may be transferred from a battery unit having a SOC value in the preset range to (or from) a battery unit having a SOC value outside the preset range. Or charge may be transferred from a battery unit having a SOC value in the preset range to (or from) a battery unit having a SOC value also in the preset range. In either case, the battery management system can ensure that when the idle state time exceeds a preset time, chrnage is transferred so that the SOC values of all the batteries is outside the preset range.

If there is a first battery unit having a SOC value that is included in the preset range among the plurality of battery units, the battery management system is arranged to select a second battery unit that is to supply or receive electrical energy to or from the first battery unit. Hence, electrical energy can be transferred to or from the first battery so as to put the SOC value of the first battery out of the preset range.

The preset range may be from 40% to 60%.

By way of summation and review, if idle state time of a battery unit exceeds preset time, charging and discharging of the battery unit may be controlled such that SOC value of each battery unit is out of a preset scope, thereby improving life of the battery.

If charging and discharging of a battery unit are controlled, electrical energy may move between a plurality of battery units provided in a battery pack, thereby minimizing loss of energy and improving life of the battery.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A battery pack, comprising:
a plurality of battery units capable of being recharged; and
a battery management system configured to control charging and discharging of the plurality of battery units,
wherein the battery management system is arranged to calculate an idle state time of the plurality of battery units by monitoring the plurality of battery units and, if the idle state time exceeds a preset time, so as not to include a state of charge, SOC, value of each of the plurality of battery units in a preset range, the battery management system is arranged to transfer electrical energy from any one of the plurality of battery units to a different battery unit, thereby controlling charging and discharging of the plurality of battery units.

2. The battery pack as claimed in claim 1, further comprising:
a switch unit at the plurality of battery units; and
a direct current-to-direct current, DC-DC, converter coupled to at least any one of the plurality of battery units through the switch unit.

3. The battery pack as claimed in claim 2,
wherein the battery management system is arranged to control the DC-DC converter and the switch unit to transfer electrical energy between the plurality of battery units.

4. The battery pack as claimed in claim 3,
wherein the battery management system is arranged to control the switch unit of a battery unit that is to supply and receive electrical energy among the plurality of battery units such that a switch unit coupled to a battery unit that is discharged among switch units coupled to one end of the DC-DC converter and a switch unit coupled to a battery unit that is charged among the switch units coupled to other end of the DC-DC converter are turned on.

5. The battery pack as claimed in any one of claims 1 to 4,
wherein, if there is a first battery unit having a SOC value that is included in the preset range among the plurality of battery units, the battery management system is arranged to select a second battery unit that is to supply or receive electrical energy to or from the first battery unit.

6. The battery pack as claimed in claim 5,
wherein the battery management system is arranged to calculate a transfer amount of electrical energy that the first battery unit is to transfer to the second battery unit or that the first battery is to receive from the second battery unit.

7. The battery pack as claimed in claim 5 or 6,
wherein the battery management system is arranged to select any one of the plurality of battery units including a SOC value that is not included in the preset range as the second battery unit.

8. The battery pack as claimed in claims 5 or 6,
wherein the battery management system is arranged to select a battery unit having a smallest SOC value among the plurality of battery units except for the first battery unit as the second battery unit and to control such that electrical energy stored in the first battery unit transfers to the second battery unit.

9. The battery pack as claimed in claim 8,
wherein the battery management system is arranged to re-calculate the SOC value of each of the plurality of battery units if the SOC value of the first battery unit continues to be included in the preset range even though the second battery unit is in a fully charged state because electrical energy has transferred from the first battery unit to the second battery unit and to re-select a new battery unit having the smallest SOC value among the battery units having the SOC values of the plurality of battery units that are not included in the preset range as a second battery unit.

10. The battery pack as claimed in claim 5 or 6,
wherein the battery management system is arranged to select a battery unit having a largest SOC value among the other battery units except for the first battery unit as a second battery unit and to control such that the first battery unit receives electrical energy from the second battery unit.

11. The battery pack as claimed in claim 5 or 6,
wherein the battery management system, if electrical energy stored in the second battery unit is the same or smaller than the transfer amount of electrical energy, is arranged to control such that electrical energy stored in the first battery unit transfers to the second battery unit.

12. The battery pack as claimed in any one of claims 1 to 11,
wherein the battery management system, if there are a plurality of first battery units having SOC values included in the preset range among the plurality of battery units, is arranged to control such that electrical energy transfer between the first battery units.

13. The battery pack as claimed in any one of claims 1 to 12, wherein the preset range is from 40% to 60%.

14. A method of controlling a battery pack including a plurality of battery units capable of being recharged and a battery management system configured to control charging and discharging of the plurality of battery units, comprising:
determining whether any of the plurality of battery units are in an idle state by monitoring the plurality of battery units;
determining whether there is a battery unit having a SOC value included in a preset range among the plurality of battery units; and
controlling charging and discharging of the plurality of battery units by transferring electrical energy between the plurality of battery units such that the SOC value of each of the plurality of battery units is out of the preset range if idle state time of the plurality of battery units exceeds preset time and there is a battery unit having a SOC value that is included in the preset range among the plurality of battery units.
